# EUROPÄISCHE PATENTSCHRIFT

(11) **EP 2 820 431 B1**
(45) Veröffentlichungstag und Bekanntmachung des Hinweises auf die Patenterteilung: **24.04.2019**
(21) Anmeldenummer: 13707124.7
(22) Anmeldetag: 15.02.2013
(51) Int. Cl.: G06T 3/00, G01R 13/02, G06T 11/20

(54) **VERFAHREN UND VORRICHTUNG ZUR DARSTELLUNG VON ORDINATEN-ABSZISSEN-WERTEPAAREN AUF EINER ANZEIGEEINRICHTUNG**
METHOD AND APPARATUS FOR DISPLAYING ORDINATE/ABSCISSA VALUE PAIRS ON A DISPLAY DEVICE
PROCÉDÉ ET DISPOSITIF DE REPRÉSENTATION DE PAIRES DE VALEURS D'ORDONNÉES ET D'ABSCISSES SUR UN SYSTÈME D'AFFICHAGE

(30) Priorität: 27.02.2012 DE 102012202941
(43) Veröffentlichungstag der Anmeldung: 07.01.2015
(73) Patentinhaber: Rohde & Schwarz GmbH & Co. KG, 81671 München (DE)
(72) Erfinder: SCHMIDT, David, 80798 München (DE)
(74) Vertreter: Körfer, Thomas
(86) Internationale Anmeldenummer: PCT/EP2013/053069
(87) Internationale Veröffentlichungsnummer: WO 2013/127644

(56) Entgegenhaltungen:
- EP-A1- 0 919 818
- EP-A2- 0 209 226
- EP-A2- 0 937 987
- WO-A1-96/37785
- DE-A1-102006 047 994
- US-A1- 2010 194 377

## Beschreibung

Die Erfindung betrifft ein Verfahren und eine Vorrichtung zur Darstellung von Ordinaten-Abszissen-Wertepaaren auf einer Anzeigeeinrichtung.

Für die grafische Darstellung von Messwerten in Messgeräten bzw. -systemen, beispielsweise in Spektrum- oder Netzwerkanalysatoren, werden standardmäßig Anzeige-Einrichtungen mit diskreten Anzeigepunkten - Pixelgrafik - verwendet. Die Auflösung derartiger Anzeige-Einrichtungen ist aufgrund der begrenzten Anzahl von Anzeigepunkten in Ordinaten- und Abszissen-Richtung limitiert. Die maximale Auflösung derartiger Anzeige-Einrichtungen liegt heute beispielsweise bei 1000*600 Anzeigepunkten.

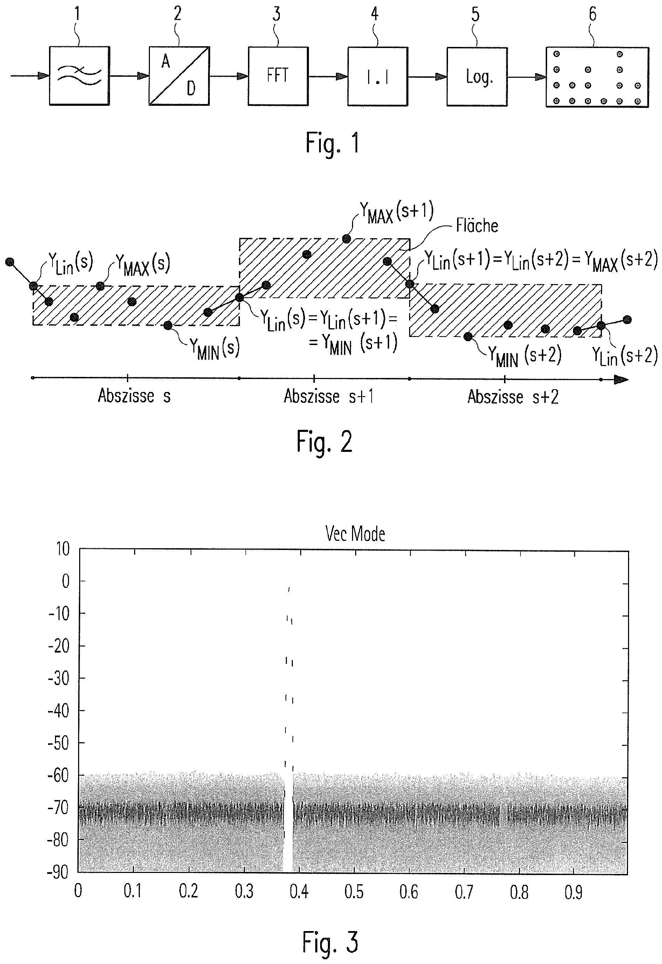

Ein Spektrumanalysator besteht gemäß Fig. 1 beispielsweise aus einem Tiefpassfilter 1 zur Frequenzbegrenzung des darzustellenden Signals, einem Analog-Digital-Wandler 2 zur Digitalisierung des darzustellenden Signals, einem Fast-Fourier-Transformator 3 (FFT) zur Berechnung der diskreten Fourierspektrallinien durch schnelle FourierTransformation, einem Betragsbildner 4 zur Ermittlung der Leistungsspektrallinien, einem Logarithmierer 5 zur Komprimierung der über einen weiten Signalbereich streuenden Leistungsspektrallinien auf den Darstellungsbereich der Anzeige-Einrichtung und einer Anzeige-Einrichtung 6 mit diskreten Anzeigepunkten in Ordinaten- und Abszissen-Richtung zur Darstellung der diskreten Leistungsspektrallinien. Das darzustellende Leistungsspektrum weist in Abszissen-Richtung eine Auflösung in Höhe der FFT-Länge N_{FFT} des FFT-Transformators 3 - typischerweise N_{FFT}=2048 - und in Ordinaten-Richtung eine Auflösung in Höhe der Wortbreite des Logarithmierers 5 - typischerweise 2¹⁶= 56636 Pegelstufen - auf. Da somit die Auflösung der darzustellenden Messwerte sowohl in Abszissen- als auch in Ordinaten-Richtung größer als die Auflösung der Anzeige-Einrichtung 6 ist, ist vor Durchführung der Darstellung der Messwerte auf der Anzeige-Einrichtung 6 die Auflösung der darzustellenden Messwerte zu reduzieren.

Die Reduktion in der Auflösung der darzustellenden Messwerte in der Abszissen-Richtung führt nachteilig zu einem Informationsverlust der darzustellenden Messwerte in Ordinaten-Richtung. Starke Schwankungen der darzustellenden Messwerte über einen größeren Wertebereich in der Ordinaten-Richtung bewirken somit insbesondere bei einer Echtzeit-Datenerfassung und -anzeige einen nicht mehr vertretbaren Genauigkeitsfehler.

Aus der DE 10 2006 047 994 A1 ist ein Verfahren zur Darstellung von Ordinaten-Abszissen-Wertepaaren auf einer Anzeige-Einrichtung bekannt, das eine geringere Auflösung in Ordinaten- und Abszissen-Richtung als die Auflösung der Ordinaten-Abszissen-Wertepaare aufweist. Um den Informationsverlust in der Darstellung der Ordinaten-Abszissen-Wertepaare aufgrund einer geringeren Auflösung der Anzeige-Einrichtung zu minimieren, werden jeweils Abszissenbereiche definiert, die sich von einer jeweils linksseitigen Abszissenbereichsgrenze im halben Abstand zwischen dem jeweiligen Abszissenwert und dem jeweils linksseitig benachbarten Abszissenwert der Anzeige-Einrichtung bis zu einer jeweils rechtsseitigen Abszissenbereichsgrenze im halben Abstand zwischen dem jeweiligen Abszissenwert und dem jeweils rechtsseitig benachbarten Abszissenwert erstrecken. An den einzelnen Abszissenbereichsgrenzen werden mittels Interpolation interpolierte Ordinatenwerte berechnet. Für jeden Abszissenbereich wird jeweils ein maximaler und ein minimaler Ordinatenwert aus allen innerhalb des Abszissenbereiches liegenden Ordinatenwerten zuzüglich der an den Abszissenbereichsgrenzen interpolierten Ordinatenwerten ermittelt. Die in der DE 10 2006 047 994 A1 beschriebene Anzeige-Einrichtung enthält gemäß Fig. 2 in jedem Abszissenbereich jeweils eine Fläche zwischen den beiden Abszissenbereichsgrenzen und dem ermittelten maximalen und minimalen Ordinatenwert.

Das in der DE 10 2006 047 994 A1 beschriebene Verfahren erzeugt keine Häufigkeitswerte innerhalb einer Histogramm-Darstellung. Eine Triggerung auf Häufigkeiten ist somit nicht möglich. Außerdem eignet sich eine derartige Signalauswertung und Darstellung für Signale mit einem bestimmten Grundrauschen (Rauschteppich) nicht, da die Darstellung von Flächen gegenüber einer Darstellung von Punktansammlungen eine für Grundrauschen untypische und unnatürliche Darstellungsform ist. Außerdem ist das Maximum der Häufigkeit des Grundrauschens verfahrensbedingt in der Histogramm-Darstellung eines sinusförmigen Grundsignals mit überlagertem Grundrauschen gemäß Fig. 3 um einige Dezibel gegenüber einer korrekten Darstellung nach unten verschoben.

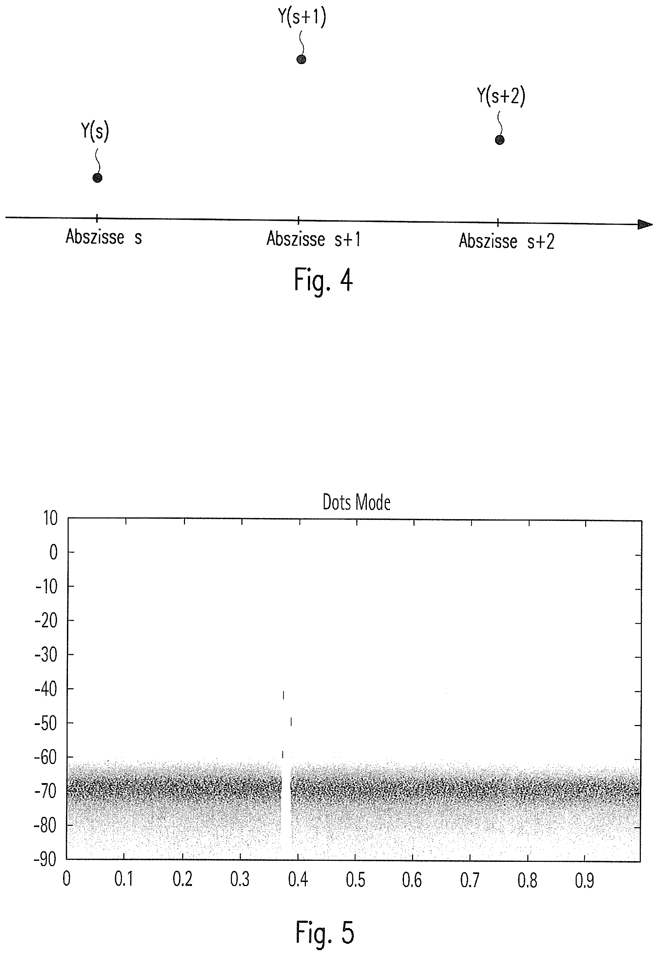

In einer punktförmigen Darstellung gemäß Fig. 4 werden nur die einzelnen gemessenen Ordinaten-Werte zu den einzelnen Abszissen-Werten ohne Berechnung zusätzlicher interpolierter Ordinaten-Werte erfasst und auf Ordinaten-Abszissen-Wertepaare in der Auflösung der Anzeige-Einrichtung umgesetzt. In diesem Fall werden in einer Histogramm-Darstellung gemäß Fig. 5 bei konstanten Spektralanteilen mit steilen Flanken - beispielsweise bei einem als Spektrallinie auftretenden sinusförmigen Signalanteil - nur unverbundene Punktansammlungen dargestellt, die gegenüber interpolierten Signalverläufen für den Betrachter schlechter zu erkennen sind.

Die DE 10 2006 047 994 A1 offenbart eine flächige Darstellung und damit keine punktförmige Darstellung von Ordinaten-Abszissen-Wertepaaren.

Aus der EP 0 937 987 A2 geht zwar die Ermittlung eines zufälligen Ordinaten-Wertes hervor. Es werden aber immer zwei zufällige Ordinaten-Werte je Spalte erzeugt.

Aufgabe der Erfindung ist es deshalb, ein Verfahren und eine Vorrichtung zur Darstellung von Ordinaten-Abszissen-Wertepaaren auf einer Anzeige-Einrichtung mit einer geringeren Auflösung in Abszissen- und vor allem in Ordinaten-Richtung gegenüber der Auflösung der Ordinaten-Abszissen-Wertepaare zu schaffen, das beziehungsweise die insbesondere im Fall einer Histogramm-Darstellung zu keinem fehlerhaften und/oder schwer erkennbaren Kurvenverlauf führt.

Die Aufgabe wird durch ein Verfahren zur Darstellung von Ordinaten-Abszissen-Wertepaaren auf einer Anzeigeeinrichtung mit den Merkmalen des Patentanspruchs 1 und durch eine Vorrichtung zur Darstellung von Ordinaten-Abszissen-Wertepaaren auf einer Anzeigeeinrichtung mit den Merkmalen des Patentanspruchs 9 gelöst. Vorteilhafte technische Weiterbildungen sind in den jeweils abhängigen Patentansprüchen aufgeführt.

Vorab ist festzustellen, dass in der folgenden Darstellung der Einfachheit halber die Abszissen-Auflösung der Anzeige-Einrichtung der Abszissenauflösung der Messwerte entspricht. Der Betriebsfall einer höheren Abszissenauflösung der Messwerte, die eine Reduzierung der Abszissenauflösung in der Signalverarbeitung des Messgeräts bedingt, ist trivial und von der Erfindung mit abgedeckt.

Erfindungsgemäß werden zu den gemessenen Ordinaten-Werten an den einzelnen Abszissen-Werten zusätzliche interpolierte Ordinaten-Werte in den halben Abständen zwischen den einzelnen Abszissen-Werten ermittelt und für jeden Abszissen-Wert jeweils der maximale Ordinaten-Wert und der minimale Ordinaten-Wert aus dem zum jeweiligen Abszissen-Wert gemessenen Ordinaten-Wert und den beiden links- und rechtsseitig nächst benachbarten interpolierten Ordinaten-Werten bestimmt. Schließlich wird für jeden Abszissen-Wert jeweils ein zufälliger oder pseudo-zufälliger Ordinaten-Wert ermittelt, der sich innerhalb des für den jeweiligen Abszissen-Wert ermittelten maximalen und minimalen Ordinaten-Wert-Intervalls befindet.

Hierbei ist vorzugsweise zu berücksichtigen, dass der zufällige oder pseudo-zufällige Ordinaten-Wert zwischen jeweils aufeinander folgenden Abszissen-Werten aus möglichst weit voneinander entfernten Ordinaten-Bereichen zwischen maximalen und minimalen Ordinaten-Wert stammt. Da typischerweise mehrere zeitlich aufeinanderfolgende Signalverläufe parallel verarbeitet und in einem einzigen Anzeige-Bild gemeinsam dargestellt werden, sind die zufälligen oder pseudo-zufälligen Ordinaten-Werte bei jeweils einem identischen Abszissen-Wert zwischen jeweils zwei zeitlich aufeinander folgenden Signalverläufen so auszuwählen, dass sie ebenfalls aus möglichst weit voneinander entfernten Ordinaten-Bereichen zwischen maximalen und minimalen Ordinaten-Wert stammen.

Schließlich soll bevorzugt der minimale Ordinaten-Abstand zwischen jeweils zwei zufälligen oder pseudo-zufälligen Ordinaten-Werten dem minimalen Abstand zwischen jeweils zwei in Ordinaten-Richtung aufeinander folgenden Ordinaten-Werten der erfassten Ordinaten-Abszissen-Wertepaare entsprechen, um nicht besetzte Ordinaten-Werte im Anzeige-Bild der Anzeige-Einrichtung und damit Lücken im Kurvenverlauf auf dem Anzeige-Bild zu vermeiden.

Die Auswahl eines zufälligen oder pseudo-zufälligen Ordinaten-Wertes für jeden Abszissen-Wert erfolgt vorzugsweise durch Differenzbildung zwischen dem zu jedem Abszissen-Wert jeweils ermittelten maximalen und minimalen Ordinaten-Wert, durch Ermittlung eines zugehörigen zufälligen oder pseudo-zufälligen Skalierungsfaktors zwischen null und eins, durch Multiplikation der ermittelnden Differenz mit dem zugehörigen zufälligen oder pseudo-zufälligen Skalierungsfaktor und anschließende Addition der mit dem zufälligen oder pseudo-zufälligen Skalierungsfaktor multiplizierten Differenz zwischen maximalen und minimalen Ordinaten-Wert zum minimalen Ordinaten-Wert.

Der zufällige oder pseudo-zufällige Skalierungsfaktor zur Bestimmung eines zufälligen oder pseudo-zufälligen Ordinaten-Wertes für jeden Abszissen-Wert wird bevorzugt quasi-deterministisch ermittelt. Hierzu wird bevorzugt ein zu einem Initialisierungszeitpunkt initialisierter Zähler mit jedem darzustellenden Anzeige-Bild inkrementiert und für jeden Abszissen-Wert zum Zählerstand des Zählers der zugehörige Abszissen-Wert jeweils hinzuaddiert. Zur quasideterministischen Erzeugung eines zufälligen oder pseudo-zufälligen Skalierungsfaktors werden die einzelnen Bits des um den Abszissen-Wert erhöhten Zählerstandes des Zählers diametral vertauscht. Nach der diametralen Vertauschung befinden sich beispielsweise das ursprünglich erste Bit an der Position des letzten Bits und das ursprünglich letzte Bit an der Position des ersten Bits.

Auf diese Weise weisen die zu jeweils aufeinander folgenden Abszissen-Werten jeweils gehörigen Zählerstände nicht mehr den minimalen Abstand von einem Bit auf, sondern sind aufgrund der Bit-Vertauschung weitest möglich voneinander beabstandet.

Werden zusätzlich mehrere Signalverläufe parallel verarbeitet und dargestellt, so kann ein weitest möglicher Abstand zwischen den zufälligen oder pseudo-zufälligen Skalierungsfaktoren, die bei identischen Abszissen-Wert jeweils zu zwei aufeinander folgenden Signalverläufen gehören, vorzugsweise dadurch erzielt werden, dass der Zählerstand des Zählers vor der Addition des Abszissen-Wertes um eine Anzahl von Schiebeschritten nach links verschoben wird, die dem Log-2-Wert der Anzahl von parallel verarbeiteten Signalverläufen entspricht. Anschließend wird der links verschobene Zählerstand des Zählers um einen der Position des jeweiligen darzustellenden Signalverlauf in der Sequenz von sequentiell erfassten und parallel verarbeiteten Signalverläufen entsprechenden Wert erhöht. Die nach der Addition des Abszissen-Wertes sich anschließende diametrale Vertauschung der Bits des somit geänderten Zählerstandes ergibt für zwei aufeinander folgende Signalverläufe bei identischem Abszissen-Wert jeweils zufällige oder pseudo-zufällige Skalierungsfaktoren, die sich weitest möglich voneinander unterscheiden.

Der für jeden Abszissen-Wert jeweils ermittelte zufällige oder pseudo-zufällige Ordinaten-Wert, der sich aus der Multiplikation des zufälligen oder pseudo-zufälligen Skalierungsfaktors mit der Differenz zwischen maximalen und minimalen Ordinaten-Wert und einer anschließenden Addition mit dem minimalen Ordinaten-Wert ergibt, wird bevorzugt einer Quantisierung zugeführt, in der der zufällige oder pseudo-zufällige Ordinaten-Wert auf einen Ordinaten-Wert in der Ordinaten-Auflösung der Anzeige-Einrichtung umgesetzt wird. Optional kann aus allen Ordinaten-Abszissen-Wertepaaren mit den zugehörigen zufälligen oder pseudo-zufälligen Ordinaten-Werten ein bestimmter zusammenhängender Ausschnitt von Ordinaten-Abszissen-Wertepaaren im Rahmen einer Vergrößerungs-Funktion (Zoom-Funktion) ausgewählt werden und anschließend mittels Quantisierung auf die Bildpunkte der Anzeige-Einrichtung umgesetzt werden.

Ein Ausführungsbeispiel des erfindungsgemäßen Verfahrens und der erfindungsgemäßen Vorrichtung zur Darstellung von Ordinaten-Abszissen-Wertepaaren auf einer Anzeigeeinrichtung werden im Folgenden anhand der Zeichnung im Detail erläutert. Die Figuren der Zeichnung zeigen:
- Fig. 1: ein Blockdiagramm eines Spektrumanalysators,
- Fig. 2: eine flächenförmige Ordinaten-Abszissen-Darstellung von Ordinaten-Abszissen-Wertepaaren nach dem Stand der Technik,
- Fig. 3: ein Histogramm einer flächenförmigen Ordinaten-Abszissen-Darstellung von Ordinaten-Abszissen-Wertepaaren nach dem Stand der Technik,
- Fig. 4: eine punktförmige Ordinaten-Abszissen-Darstellung von Ordinaten-Abszissen-Wertepaaren,
- Fig. 5: ein Histogramm einer punktförmigen Ordinaten-Abszissen-Darstellung von Ordinaten-Abszissen-Wertepaaren nach dem Stand der Technik,
- Fig. 6: eine erfindungsgemäße Ordinaten-Abszissen-Darstellung von Ordinaten-Abszissen-Wertepaaren,
- Fig. 7: ein Histogramm einer erfindungsgemäßen Ordinaten-Abszissen-Darstellung von Ordinaten-Abszissen-Wertepaaren,
- Fig. 8: ein Flussdiagramm eines Ausführungsbeispiels des erfindungsgemäßen Verfahrens zur Darstellung von Ordinaten-Abszissen-Wertepaaren auf einer Anzeigeeinrichtung,
- Fig. 9A: ein Blockdiagramm einer ersten Ausführungsform der erfindungsgemäßen Vorrichtung zur Darstellung von Ordinaten-Abszissen-Wertepaaren auf einer Anzeigeeinrichtung und
- Fig. 9B: ein Blockdiagramm einer zweiten Ausführungsform der erfindungsgemäßen Vorrichtung zur Darstellung von Ordinaten-Abszissen-Wertepaaren auf einer Anzeigeeinrichtung.

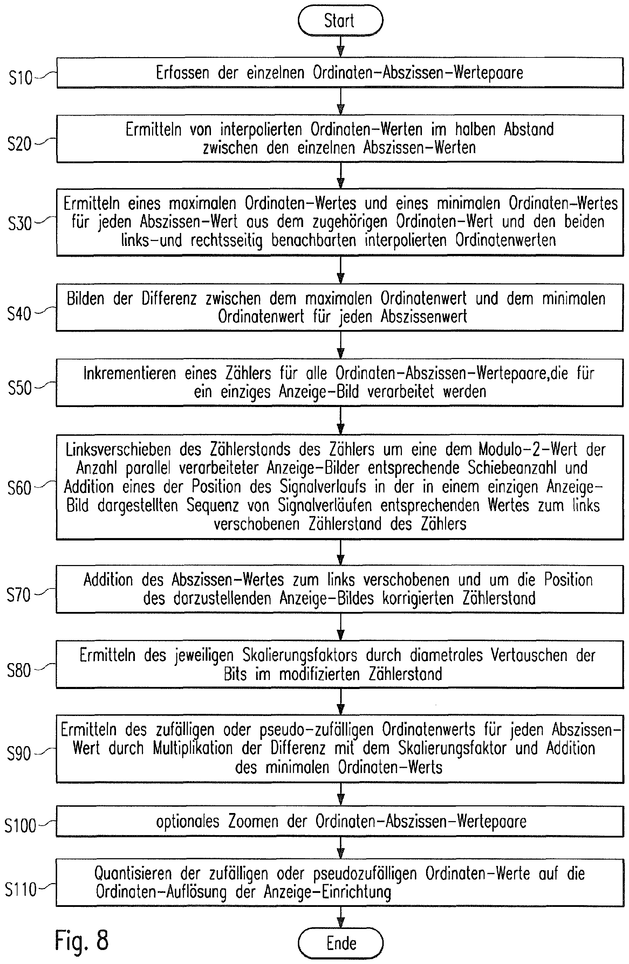

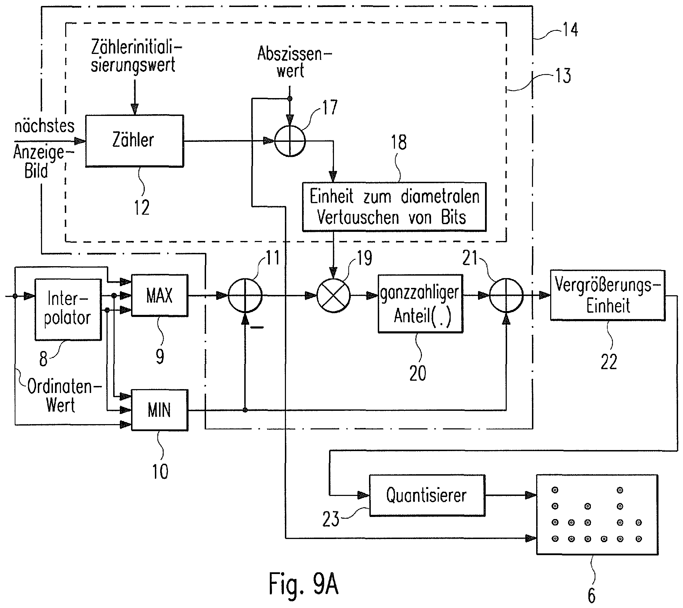

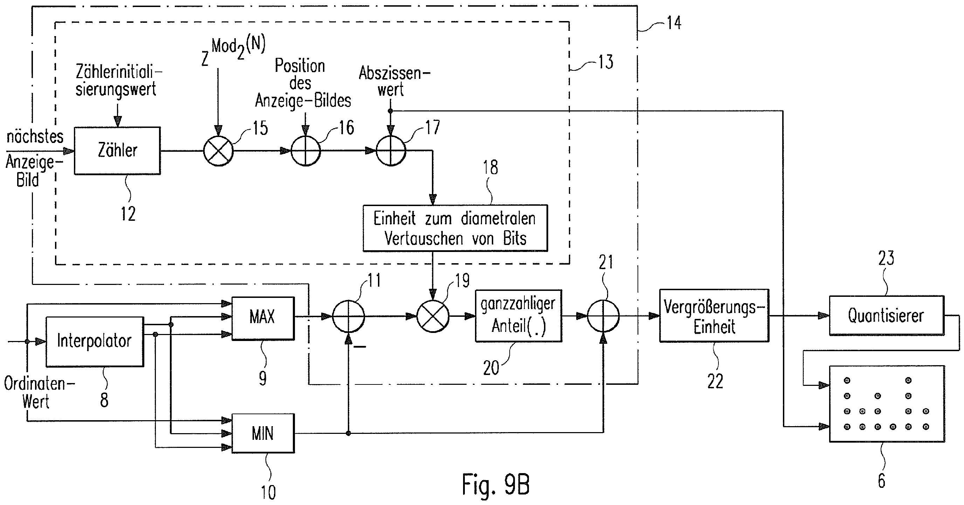

Im Folgenden wird das Ausführungsbeispiel erfindungsgemäßen Verfahrens zur Darstellung von Ordinaten-Abszissen-Wertepaaren auf einer Anzeigeeinrichtung anhand des Flussdiagramms in Fig. 8 sowie die beiden dazu korrespondierenden Ausführungsformen der erfindungsgemäßen Vorrichtung zur Darstellung von Ordinaten-Abszissen-Wertepaaren auf einer Anzeigeeinrichtung in den Figuren 9A und 9B im Detail erläutert.

Im ersten Verfahrensschritt S10 werden die einzelnen Ordinaten-Abszissen-Wertepaare des Messsignals mithilfe eines Messgerätes erfasst, wie es obig anhand der in Fig. 1 dargestellten Vorrichtung für einen Spektrumanalysator beispielhaft beschrieben wurde. Die einzelnen Ordinaten-Abszissen-Wertepaare werden typischerweise in einem Akquisition-oder Bildschirm-Speicher zwischengepuffert. Werden mehrere Anzeigebilder sequenziell erfasst, parallel verarbeitet und in einer einzigen Bildschirm-Darstellung präsentiert, beispielsweise die in einzelnen Zeitpunkten jeweils erfassten Spektren eines Messsignals als Spektrogramm oder als Histogramm in einer dreidimensionalen Darstellung, so ist auf eine ausreichende Speicherkapazität des Akquisition- oder Bildschirm-Speichers und auf eine entsprechend hohe Signalverarbeitungsleistung in Echtzeit der im Messgerät integrierten Rechnereinheit zu achten.

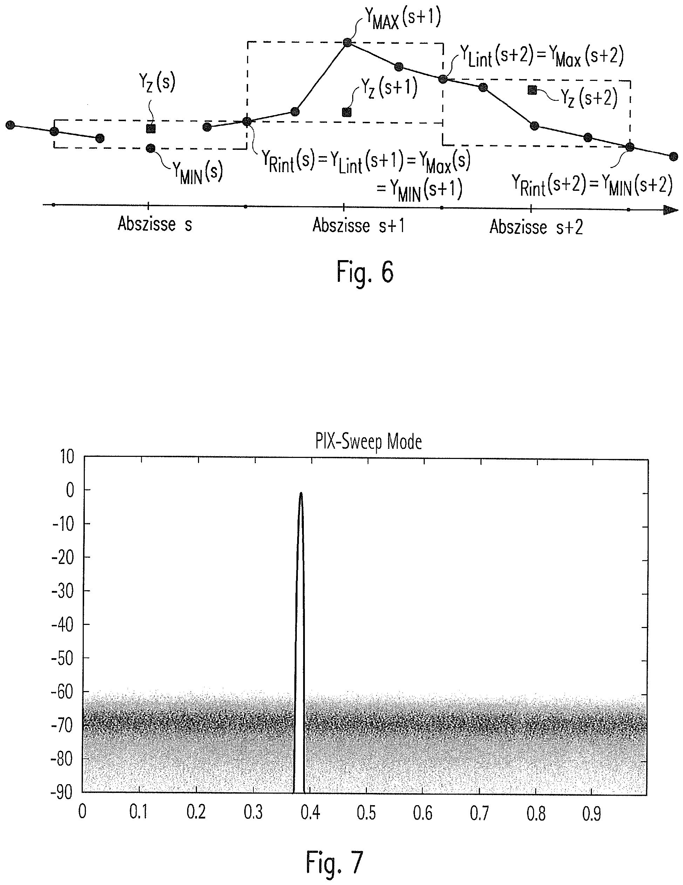

Im nächsten Verfahrensschritt S20 wird in einem Interpolator 8 für jeden Abszissen-Wert der im halben Abstand zum linksseitig und rechtsseitig benachbarten Abszissen-Wert jeweils positionierte Ordinaten-Wert berechnet. Auf diese Weise ergeben sich, wie in Fig. 6 schematisch für drei Abszissen-Werte dargestellt ist, die linksseitig zu den einzelnen Abszissen-Werten s, s+1, s+2 benachbarten interpolierten Ordinaten-Werte Y_{Lint}(s), Y_{Lint}(s+1) und Y_{Lint}(s+2) und die rechtsseitig zu den einzelnen Abszissen-Werten s, s+1, s+2 benachbarten interpolierten Ordinaten-Werte Y_{Rint(}s), Y_{Rint}(s+1) und Y_{Rint}(s+2).

Auf der Basis dieser interpolierten Ordinaten-Werte und der zu den einzelnen Abszissen-Werten jeweils gemessenen Ordinaten-Werte werden im darauf folgenden Verfahrensschritt S30 in einem Maximalwertbildner 9 für jeden Abszissen-Wert der maximale Ordinaten-Wert aus dem gemessenen Ordinaten-Wert zum jeweiligen Abszissen-Wert und den beiden links- und rechtsseitig nächst benachbarten interpolierten Ordinaten-Werten ermittelt. Äquivalent wird in einem Minimalwertbildner 10 für jeden Abszissen-Wert der minimale Ordinaten-Wert aus dem gemessenen Ordinaten-Wert zum jeweiligen Abszissen-Wert und dem beiden links- und rechtsseitig nächst benachbarten interpolierten Ordinaten-Werten ermittelt. Gemäß der schematischen Darstellung in Fig. 6 ergeben sich somit die maximalen Ordinaten-Werte Y_{MAX}(s), Y_{MAX}(s+1) und Y_{MAX}(s+2) und die minimalen Ordinaten-Werte Y_{MIN}(s), Y_{MIN}(s+1) und Y_{MIN}(s+2) für die einzelnen Abszissen-Werte s, s+1 und s+2.

In einem sich an den Maximalwertbildner 9 und an den Minimalwertbildner 10 anschließenden Subtrahierer 11, der zu einer übergeordneten Einheit 14 zum Auswählen eines zufälligen oder pseudo-zufälligen Ordinaten-Wertes gehört, wird im nächsten Verfahrensschritt S40 die Differenz zwischen maximalen Ordinaten-Wert und minimalen Ordinaten-Wert für jeden einzelnen Abszissen-Wert ermittelt.

Im darauf folgenden Verfahrensschritt S50 wird ein Zähler 12, der zu einer übergeordneten Einheit 13 zur Ermittlung eines zufälligen oder pseudo-zufälligen Skalierungsfaktor sowie zu einer übergeordneten Einheit 14 zum Auswählen eines zufälligen oder pseudo-zufälligen Ordinaten-Wertes gehört und der zu Beginn einer Messung mit einem Zähler-Initialisierungswert initialisiert wird, für die Signalverarbeitung aller Ordinaten-Abszissen-Wertepaare, die für ein einziges Anzeige-Bild verarbeitet werden, jeweils einmal um einen Faktor eins inkrementiert.

Im nächsten Verfahrensschritt S60, der einzig in der in Fig. 9B dargestellten zweiten Ausführungsform einer erfindungsgemäßen Vorrichtung zur Darstellung von Ordinaten-Abszissen-Wertepaaren auf einer Anzeigeeinrichtung durchgeführt wird, wird der Zählerstand des Zählers 12 ausgelesen und in einem zweiten Multiplizierer 15, der ebenfalls zu einer übergeordneten Einheit 13 zur Ermittlung eines zufälligen oder pseudo-zufälligen Skalierungsfaktor sowie zu einer übergeordneten Einheit 14 zum Auswählen eines zufälligen oder pseudo-zufälligen Ordinaten-Wertes gehört, mit einem Faktor 2^{Log-2 (N)} multipliziert. Bei dem Faktor Log-2(N) handelt es sich um den Log-2-Wert der Anzahl N von sequenziell erfassten und parallel für die Darstellung in einem einzigen Anzeige-Bild verarbeiteten Signalverläufe, wobei N eine Zweier-Potenz darstellt. Der Zählerstand des Zählers 12 wird also um eine dem Log-2-Wert der Anzahl N von parallel verarbeiteten Signalverläufen entsprechende Anzahl von Schiebeschritten nach links verschoben. Anstelle eines Multiplizierers 15 kann alternativ auch ein Schieberegister verwendet werden.

Nach dem Linksverschieben des Zählerstands wird in demselben Verfahrensschritt S60 in einem dem zweiten Multiplizierer 15 nachgeschalteten dritten Addierer 16, der ebenfalls zu einer übergeordneten Einheit 13 zur Ermittlung eines zufälligen oder pseudo-zufälligen Skalierungsfaktor sowie zu einer übergeordneten Einheit 14 zum Auswählen eines zufälligen oder pseudo-zufälligen Ordinaten-Wertes gehört, in die durch die Linksverschiebung rechtsseitig freiwerdenden BitPositionen des den Zählerstand beinhaltenden Datenwortes ein der Position des Signalverlaufs in der Sequenz von sequenziell erfassten und parallel verarbeiteten Signalverläufen entsprechender Wert zum links verschobenen Zählerstand addiert. Ist die Anzahl N von parallel verarbeiteten Signalverläufen keine Zweier-Potenz, so wird der Multiplizierer 15 nicht verwendet und der dritte Addierer 16 addiert bei jedem einzelnen Signalverlauf den Wert N zum ausgelesenen Zählerstand hinzu.

In beiden Fällen wird auf diese Weise für jeden einzelnen in einem einzigen Anzeige-Bild dargestellten Signalverlauf jeweils ein spezifisches Datenwort generiert, aus dem nachfolgend für jeden einzelnen in einem einzigen Anzeige-Bild dargestellten Signalverlauf jeweils ein spezifischer Skalierungsfaktor erzeugt wird.

Im darauf folgenden Verfahrensschritt S70, der wieder in beiden Ausführungsformen der erfindungsgemäßen Vorrichtung identisch durchgeführt wird, wird in einem zweiten Addierer 17, der zu der übergeordneten Einheit 13 zur Ermittlung eines zufälligen oder pseudo-zufälligen Skalierungsfaktors sowie zu der übergeordneten Einheit 14 zum Auswählen eines zufälligen oder pseudo-zufälligen Ordinaten-Wertes gehört, zum ausgelesenen Zählerstand gemäß der ersten Ausführungsform der erfindungsgemäßen Vorrichtung nach Fig. 9A bzw. zum ausgelesenen und um die Position des jeweiligen Signalverlaufs korrigierten Zählerstand gemäß der zweiten Ausführungsform der erfindungsgemäßen Vorrichtung nach Fig. 9B der jeweilige Abszissen-Wert hinzuaddiert. Auf diese Weise wird für jeden einzelnen Abszissen-Wert jeweils ein spezifisches Datenwort generiert, aus dem nachfolgend für jeden einzelnen Abszissen-Wert jeweils ein spezifischer Skalierungsfaktor erzeugt wird.

Die Kombination der Verfahrensschritte S60 und S70 ergibt für jeden Abszissen-Wert und gleichzeitig für jeden in einem einzigen Anzeige-Bild dargestellten Signalverlauf jeweils ein spezifisches Datenwort, aus dem nachfolgend für jeden Abszissen-Wert und gleichzeitig für jeden in einem einzigen Anzeige-Bild dargestellten Signalverlauf jeweils ein spezifischer Skalierungsfaktor erzeugt wird.

Im nächsten Verfahrensschritt S80 werden in einer dem zweiten Addierer 17 nachfolgenden Einheit 18 zum diametralen Vertauschen von Bits, die ebenfalls zur übergeordneten Einheit 13 zur Ermittlung eines zufälligen oder pseudo-zufälligen Skalierungsfaktor sowie zur übergeordneten Einheit 14 zum Auswählen eines zufälligen oder pseudo-zufälligen Ordinaten-Wertes gehört, die einzelnen Bits des in den einzelnen vorausgehenden Signalverarbeitungsstufen modifizierten Zählerstandes des Zählers 12 diametral vertauscht. Auf diese Weise sind beispielsweise das ursprünglich erste Bit des den modifizierten Zählerstand enthaltenden Datenwortes in der letzten Bitposition und das ursprüngliche letzte Bit des den modifizierten Zählerstand enthaltenden Datenwortes in der ersten Bitposition abgelegt. Während jeweils zwei aufeinander folgende ursprüngliche Datenworte, die sich auf zwei benachbarte Abszissen-Werte oder auf zwei unmittelbar aufeinanderfolgende Signalverläufe im Anzeige-Bild beziehen, sich jeweils nur um den Wert 1 voneinander unterscheiden, unterscheiden sich die aus diesen Datenworten durch diametrale Bit-Vertauschung erzeugten zugehörigen Datenworte jeweils um einen höheren Wert voneinander und ergeben somit Skalierungsfaktoren, die erheblich zueinander streuen und somit pseudo-zufällige Skalierungsfaktoren darstellen.

Anstelle der Einheit 18 zum diametralen Vertauschen von Bits kann alternativ auch ein rückgekoppeltes Schieberegister verwendet werden, das in Abhängigkeit des den modifizierten Zählerstand beinhaltenden und an seinem Eingang anliegenden Datenwortes an seinem Ausgang einen pseudo-zufälligen Skalierungsfaktor generiert. Schließlich kann alternativ zur Einheit 18 zum diametralen Vertauschen von Bits auch eine Einheit Verwendung finden, die unter Ausnutzung eines stochastischen physikalischen Effektes, beispielsweise unter Ausnutzung des stochastischen thermischen Rauschens eines in dieser Einheit integrierten Halbleiter-Transistors bzw. Halbleiter-Diode, einen Zufallswert erzeugt. Wird am Eingang einer derartigen Einheit ein neues, einen modifizierten Zählerstand beinhaltendes Datenwort angelegt, so wird am Ausgang dieser Einheit ein neuer Zufallswert generiert, der als zufälliger Skalierungsfaktor verwendet werden kann.

Im darauf folgenden Verfahrensschritt S90 wird in einem an den Subtrahierer 11 sich anschließenden ersten Multiplizierer 19, der ebenfalls zu der übergeordneten Einheit 14 zum Auswählen eines zufälligen oder pseudo-zufälligen Ordinaten-Wertes gehört, die für jeweils einen Abszissen-Wert ermittelte Differenz zwischen dem maximalen Ordinaten-Wert und dem minimalen Ordinaten-Wert mit dem für den zugehörigen Abszissen-Wert in der Einheit 18 zum diametralen Vertauschen von Bits erzeugten pseudo-zufälligen Skalierungsfaktor multipliziert.

In demselben Verfahrensschritt S90 wird in einer an den ersten Multiplizierer 19 sich anschließenden Einheit 20 zur Bildung eines ganzzahligen Anteils, der ebenfalls zu der übergeordneten Einheit 14 zum Auswählen eines zufälligen oder pseudo-zufälligen Ordinaten-Wertes gehört, der im Multiplikationsergebnis vorhandene fraktionale Anteil im Hinblick auf die Erzielung eines ganzzahligen Ordinaten-Wertes entfernt.

Schließlich wird im selben Verfahrensschritt S90 in einem an die Einheit 20 zur Bildung eines ganzzahligen Anteils sich anschließenden ersten Addierer 21, der ebenfalls zu der übergeordneten Einheit 14 zum Auswählen eines zufälligen oder pseudo-zufälligen Ordinaten-Wertes gehört, der zum jeweiligen Abszissen-Wert gehörige minimale Ordinaten-Wert zum ganzzahligen Multiplikationsergebnis addiert. Auf diese Weise wird für jeden einzelnen Abszissen-Wert bzw. für jeden einzelnen in einem einzigen Anzeige-Bild dargestellten Signalverlauf jeweils ein zufälliger oder pseudo-zufälliger Ordinaten-Wert erzeugt. Aus der schematischen Ordinaten-Abszissen-Darstellung der Fig. 6 sind die als gefüllte Quadrate dargestellten zufälligen oder pseudo-zufälligen Ordinaten-Werte Y_{z}(s), Y_{z}(s+1) und Y_{z}(s+2) zu den einzelnen Abszissen-Werten s, s+1 und s+2 dargestellt.

Der darauf folgende Verfahrensschritt S100, der optional durchgeführt werden kann, enthält eine Zoom- bzw. Vergrößerungs-Funktion. Hierzu wird in einer an den ersten Addierer 21 sich anschließenden Vergrößerungs-Einheit 22 ein zusammenhängender Anteil von Ordinaten-Abszissen-Wertepaaren aus allen Ordinaten-Abszissen-Wertepaaren, die sich aus den ermittelten zufälligen oder pseudo-zufälligen Ordinaten-Werten und den zugehörigen Abszissen-Werten ergeben, ausgewählt, während alle übrigen Ordinaten-Abszissen-Wertepaare nicht weiter berücksichtigt werden.

Im abschließenden Verfahrensschritt S110 werden die zufälligen oder pseudo-zufälligen Ordinatenwerten aller im nicht vergrößerten Betriebsfall jeweils verwendeten Ordinaten-Abszissen-Wertepaare oder der im vergrößerten Betriebsfall jeweils ausgewählten Ordinaten-Abszissen-Wertepaare in einem anschließenden Quantisierer 23 in entsprechende Ordinaten-Werte in der Ordinaten-Auflösung der Anzeige-Einrichtung 6 umgesetzt. Die an die Anzahl von Bildpunkten der Anzeige-Einrichtung 6 angepassten Ordinaten-Abszissen-Wertepaare werden nach einer optionalen Zwischenspeicherung in einem in den Figuren 9A und 9B jeweils nicht dargestellten Bildschirmspeicher an die Anzeige-Einrichtung 6 zur Darstellung übertragen.

Das in Fig. 7 dargestellte Histogramm eines Spektrums eines sinusförmigen Signals mit überlagertem Grundrauschen, das aus einem erfindungsgemäßen Verfahren gemäß Fig. 8 hervorgeht und auf einer erfindungsgemäßen Vorrichtung gemäß Fig. 9A oder 9B implementiert ist, weist gegenüber den Histogrammen in den Figuren 3 und 5, die dasselbe Messsignal mit Verfahren bzw. mit Vorrichtungen nach dem Stand der Technik darstellen, eine deutlich schärfere Darstellung des singulären Spektrallinie bei der Frequenz des sinusförmigen Signals auf. Zusätzlich weist die maximale Häufigkeit des Grundrauschens gegenüber der Darstellung nach dem Stand der Technik in Fig. 3 einen korrekten Signalpegel auf. Auch vermittelt das Grundrauschen in der erfindungsgemäßen Darstellung gemäß Fig. 7 ein typischeren und natürlicheren Eindruck als die Darstellung nach dem Stand der Technik in Fig. 3.

Die Erfindung ist nicht auf die dargestellten Ausführungsformen beschränkt. Von der Erfindung sind insbesondere alle Kombinationen aller in den Ansprüchen beanspruchten Merkmale, aller in der Beschreibung offenbarten Merkmale und alle in den Figuren der Zeichnung dargestellten Merkmale mit abgedeckt. Auch eignet sich die Erfindung zur Darstellung unterschiedlicher Signale nicht nur eines Spetkrumanalysators sondern auch z. B. eines Oszilloskops.

## Patentansprüche

1. Verfahren zur Darstellung von Ordinaten-Abszissen-Wertepaaren auf einer Anzeigeeinrichtung mit diskreten Anzeigepunkten in Abszissen- und Ordinatenrichtung mit folgenden Verfahrensschritten, die von einer Recheneinrichtung ausgeführt werden:
Ermitteln eines interpolierten Ordinaten-Wertes (Y_{Lint}(s),Y_{Lint}(s+1),Y_{Lint}(s+2),Y_{Rint(}s),Y_{Rint}(s+1),Y_{Rint}(s+2)) im halben Abszissenabstand zwischen dem jeweiligen Abszissenwert (s,s+1,s+2) und dem jeweils linksseitigen und rechtsseitigen Abszissen-Wert der Anzeigepunkte,
Ermitteln eines maximalen Ordinatenwertes (Y_{MAX}(s),Y_{MAX}(s+1),Y_{MAX}(s+2)) und eines minimalen Ordinatenwertes (Y_{MIN}(s),Y_{MIN}(s+1),Y_{MIN}(s+2)) aus dem Ordinatenwert des jeweiligen Ordinaten-Abszissen-Wertepaares, dem jeweilig linksseitig interpolierten Ordinaten-Wert (Y_{Lint}(s),Y_{Lint}(s+1),Y_{Lint}(s+2)) und dem jeweilig rechtsseitig interpolierten Ordinaten-Wert (Y_{Rint(}s),Y_{Rint}(s+1),Y_{Rint}(s+2)) und
Auswählen eines zufälligen oder pseudo-zufälligen Ordinatenwertes (Y_{Z}(s),Y_{Z}(s+1),Y_{Z}(s+2)) zwischen dem ermittelten maximalen Ordinatenwert (Y_{MAX}(s),Y_{MAX}(s+1), Y_{MAX}(s+2)) und dem ermittelten minimalen Ordinatenwert (Y_{MIN}(s),Y_{MIN}(s+1),Y_{MIN}(s+2)) zu jedem Abszissen-Wert (s, s+1, s+2) der Anzeigepunkte mittels Multiplikation der Differenz zwischen dem jeweiligen ermittelten maximalen Ordinatenwert (Y_{MAX}(s),Y_{MAX}(s+1),Y_{MAX}(s+2)) und dem jeweiligen ermittelten minimalen Ordinatenwert (Y_{MIN}(s),Y_{MIN}(s+1),Y_{MIN}(s+2)) mit einem zum jeweiligen Abszissen-Wert (s, s+1, s+2) gehörigen zufälligen Skalierungsfaktor,
wobei der zum jeweiligen Abszissen-Wert (s, s+1, s+2) gehörige zufällige Skalierungsfaktor durch diametrales Vertauschen der Bits eines um den zugehörigen Abszissenwert (s,s+1,s+2) erhöhten und für jedes einzelne Anzeige-Bild jeweils inkrementierten Zählerstandes eines Zählers bestimmt wird, und
Quantisieren der ausgewählten zufälligen oder pseudo-zufälligen Ordinatenwerte (Y_{Z}(s),Y_{Z}(s+1),Y_{Z}(s+2)) der einzelnen Ordinaten-Abszissen-Wertepaare zur Darstellung auf dem Anzeigebild der Anzeigeeinrichtung in die Ordinatenauflösung der Anzeigepunkte, wobei die Ordinatenauflösung der Anzeigepunkte gegenüber der Ordinatenauflösung der Ordinaten-Abszissen-Wertepaare reduziert ist.

2. Verfahren nach Anspruch 1,
**dadurch gekennzeichnet,**
**dass** zur Auswahl des zufälligen oder pseudo-zufälligen Ordinatenwertes (Y_{Z}(s),Y_{z}(s+1),Y_{Z}(s+2)) zwischen dem maximalen Ordinatenwert (Y_{MAX}(s),Y_{MAX}(s+1),Y_{MAX}(s+2)) und dem minimalen Ordinatenwert (Y_{MIN}(s),Y_{MIN}(s+1),Y_{MIN}(s+2)) ein zugehöriger zufälliger oder pseudo-zufälliger Skalierungsfaktor in einem Wertebereich zwischen null und eins ermittelt wird, mit dem die Differenz zwischen dem maximalen Ordinatenwert (Y_{MAX}(s),Y_{MAX}(s+1),Y_{MAX}(s+2)) und dem minimalen Ordinatenwert (Y_{MIN}(s),Y_{MIN}(s+1),Y_{MIN}(s+2)) multipliziert wird.

3. Verfahren nach Anspruch 2,
**dadurch gekennzeichnet,**
**dass** der zufällige oder pseudo-zufällige Skalierungsfaktor für die Auswahl eines zu jedem Abszissenwert (s,s+1,s+2) der Anzeigepunkte gehörigen, zufälligen oder pseudo-zufälligen Ordinatenwertes (Y_{Z}(s),Y_{Z}(s+1),Y_{Z}(s+2)) zwischen zwei aufeinander folgenden Abszissenwerten (s,s+1,s+2) der Anzeigepunkte möglichst weit im Wertebereich zwischen null und eins streut.

4. Verfahren nach Anspruch 2 oder 3,
**dadurch gekennzeichnet,**
**dass** der zufällige oder pseudo-zufällige Skalierungsfaktor für die Auswahl eines zu jedem Abszissenwert (s,s+1,s+2) der Anzeigepunkte gehörigen, zufälligen oder pseudo-zufälligen Ordinatenwertes (Y_{Z}(s),Y_{Z}(s+1),Y_{Z}(s+2)) in jeweils einem identischen Abszissenwert (s,s+1,s+2) der Anzeigepunkte zwischen zwei aufeinander folgenden und parallel verarbeiteten und dargestellten Signalverläufen möglichst weit im Wertebereich zwischen null und eins streut.

5. Verfahren nach Anspruch 4,
**dadurch gekennzeichnet,**
**dass** der Zählerstand um eine dem Log-2-Wert der Anzahl von parallel verarbeiteten und dargestellten Signalverläufen entsprechende Anzahl von Schiebeschritte nach links verschoben wird und zum links verschobenen Zählerstand ein der Position des jeweiligen Signalverlaufs in der Sequenz von parallel verarbeitenden Signalverläufen entsprechender Wert hinzuaddiert wird.

6. Verfahren nach einem der Ansprüche 2 bis 5,
**dadurch gekennzeichnet,**
**dass** zur Ermittlung des zum jeweiligen Abszissenwert (s,s+1,s+2) der Anzeigepunkte gehörigen zufälligen oder pseudo-zufälligen Ordinatenwertes (Y_{Z}(s),Y_{Z}(s+1),Y_{Z}(s+2)) der zugehörige minimale Ordinatenwert (Y_{MIN}(s),Y_{MIN}(s+1), Y_{MIN}(s+2)) zu der mit dem zugehörigen zufälligen oder pseudo-zufälligen Skalierungsfaktor multiplizierten Differenz zwischen dem maximalen Ordinatenwert (Y_{MAX}(s),Y_{MAX}(s+1),Y_{MAX}(s+2)) und dem minimalen Ordinatenwert (Y_{MIN}(s),Y_{MIN}(s+1),Y_{MIN}(s+2)) addiert wird.

7. Verfahren nach Anspruch 6,
**dadurch gekennzeichnet,**
**dass** aus allen Ordinaten-Abszissen-Wertepaaren mit jeweils ausgewählten zufälligen oder pseudo-zufälligen Ordinatenwerten (Y_{Z}(s),Y_{Z}(s+1),Y_{Z}(s+2)) ein in Ordinatenrichtung verkleinerter Bereich von Ordinaten-Abszissen-Wertepaaren zur Darstellung auf dem Anzeigebild ausgewählt wird.

8. Verfahren nach einem der Ansprüche 1 bis 7,
**dadurch gekennzeichnet,**
**dass** der kleinste Abstand zwischen zwei zufälligen oder pseudo-zufälligen Ordinatenwerten (Y_{Z}(s),Y_{Z}(s+1),Y_{Z}(s+2)) dem kleinsten Abstand zwischen zwei Ordinatenwerten der Ordinaten-Abszissen-Wertepaare entspricht.

9. Vorrichtung zur Darstellung von Ordinaten-Abszissen-Wertepaaren auf einer Anzeigeeinrichtung (6) mit diskreten Anzeigepunkten in Abszissen- und Ordinatenrichtung mit
einem Interpolator (8) zum Ermitteln eines interpolierten Ordinaten-Wertes (Y_{Lint}(s),Y_{Lint}(s+1), Y_{Lint}(s+2),Y_{Rint(}s),Y_{Rint}(s+1),Y_{Rint}(s+2)) links- und rechtsseitig jedes Abszissenwertes (s,s+1,s+2),
einem Maximalwertbildner (9) zum Ermitteln eines maximalen Ordinatenwerts (Y_{MAX}(s),Y_{MAX}(s+1),Y_{MAX}(s+2)) aus dem Ordinatenwert und dem jeweiligen links- und rechtsseitig interpolierten Ordinaten-Wert (Y_{Lint}(s), Y_{Lint}(s+1),Y_{Lint}(s+2),Y_{Rint}(s),Y_{Rint}(s+1),Y_{Rint}(s+2)),
einem Minimalwertbildner (10) zum Ermitteln eines minimalen Ordinatenwerts (Y_{MIN}(s),Y_{MIN}(s+1),Y_{MIN}(s+2)) aus dem jeweiligen Ordinatenwert und dem jeweiligen links- und rechtsseitig interpolierten Ordinaten-Wert (Y_{Lint}(s), Y_{Lint}(s+1),Y_{Lint}(s+2),Y_{Rint(}s),Y_{Rint}(s+1),Y_{Rint}(s+2)) und
einer Einheit (14) zum Auswählen eines zufälligen oder pseudo-zufälligen Ordinatenwertes (Y_{Z}(s),Y_{Z}(s+1), Y_{Z}(s+2)) zwischen dem ermittelten maximalen und minimalen Ordinatenwert (Y_{MAX}(s),Y_{MAX}(s+1),Y_{MAX}(s+2),Y_{MIN}(s),Y_{MIN}(s+1), Y_{MIN}(s+2)) jedes Abszissen-Wertes,
wobei die Ordinatenauflösung der Anzeigepunkte gegenüber der Ordinatenauflösung der Ordinaten-Abszissen-Wertepaare reduziert ist,
wobei die Einheit (14) zum Auswählen eines zufälligen oder pseudo-zufälligen Ordinatenwertes (Y_{Z}(s),Y_{Z}(s+1),Y_{Z}(s+2)) einen Subtrahierer (11) zur Bildung einer Differenz zwischen dem maximalen und minimalen Ordinatenwert (Y_{MAX}(s),Y_{MAX}(s+1),Y_{MAX}(s+2),Y_{MIN}(s),Y_{MIN}(s+1),Y_{MIN}(s+2)) jedes Abszissenwertes (s,s+1,s+2), eine Einheit (13) zur Ermittlung eines zufälligen oder pseudo-zufälligen Skalierungsfaktors und einen ersten Multiplizierer (19) zur Multiplikation der Differenz zwischen dem maximalen und minimalen Ordinatenwert
(Y_{MAX}(s),Y_{MAX}(s+1),Y_{MAX}(s+2),Y_{MIN}(s), Y_{MIN}(s+1), Y_{MIN}(s+2)) mit dem zufälligen oder pseudo-zufälligen Skalierungsfaktor aufweist,
wobei die Einheit (13) zur Ermittlung eines zufälligen oder pseudo-zufälligen Skalierungsfaktors einen Zähler (12) zum Inkrementieren eines Zählerstandes mit jedem darzustellenden Anzeigenbild, einen zweiten Addierer (17) zur Addition des jeweiligen Abszissenwertes (s,s+1,s+2) zum Zählerstand des Zählers (12) und einer Einheit (18) zum diametralen Vertauschen der Bits des um den jeweiligen Abszissenwert erhöhten Zählerstandes aufweist.

10. Vorrichtung nach Anspruch 9,
**dadurch gekennzeichnet,**
**dass** die Einheit (14) zusätzlich einen ersten Addierer (21) zur Addition des minimalen Ordinatenwertes (Y_{MIN}(s), Y_{MIN}(s+1),Y_{MIN}(s+2)) und der mit dem zufälligen oder pseudo-zufälligen Skalierungsfaktor multiplizierten Differenz aufweist..

11. Vorrichtung nach Anspruch 9 oder 10,
**dadurch gekennzeichnet,**
**dass** zwischen dem Zähler (12) und dem zweiten Addierer (17) ein zweiter Multiplizierer (15) zum Linksschieben des Zählerstands um eine dem Log-2-Wert der Anzahl (N) von parallel verarbeiteten und dargestellten Signalverläufen entsprechende Anzahl von Schiebeschritte und ein dritter Addierer (16) zur Addition des links-verschobenen Zählerstandes und eines der Position des jeweiligen Signalverlaufs in der Sequenz von parallel verarbeiteten und dargestellten Signalverläufen entsprechenden Wertes geschaltet ist.

12. Vorrichtung nach einem der Ansprüche 9 bis 11,
**dadurch gekennzeichnet,**
**dass** der Einheit (14) zum Auswählen eines zufälligen oder pseudo-zufälligen Ordinatenwertes (Y_{Z}(s),Y_{Z}(s+1),Y_{Z}(s+2)) ein Quantisierer (23) zur Abbildung der für jeden Abszissenwert (s,s+1,s+2) ermittelten zufälligen oder pseudo-zufälligen Ordinatenwerte (Y_{Z}(s),Y_{Z}(s+1),Y_{Z}(s+2)) in Ordinatenwerte in der Ordinatenauflösung der Anzeigepunkte nachgeschaltet ist.

13. Vorrichtung nach Anspruch 12,
**dadurch gekennzeichnet,**
**dass** zwischen der Einheit (14) zum Auswählen eines zufälligen oder pseudo-zufälligen Ordinatenwertes (Y_{z}(s), Y_{Z}(s+1),Y_{Z}(s+2)) und dem Quantisierer (23) eine Vergrößerungs-Einheit (22) zum Auswählen eines Bereiches von Ordinaten-Abszissen-Wertepaaren geschaltet ist, der gegenüber den Ordinaten-Abszissen-Wertepaaren mit jeweils ermittelten zufälligen oder pseudo-zufälligen Ordinatenwertes (Y_{Z}(s),Y_{Z}(s+1),Y_{Z}(s+2)) verkleinert ist.

## Claims

1. Method for displaying ordinate / abscissa value pairs on a display unit with discrete display points in the abscissa and ordinate directions with the following method steps which are carried out by a computing device:
determination of an interpolated ordinate value (Y_{Lint}(s), Y_{Lint}(s+1), Y_{Lint}(s+2), Y_{Rint}(s), Y_{Rint}(s+1), Y_{Rint}(s+2)) at half the abscissa distance between the respective abscissa value (s, s+1, s+2) and the respective abscissa value of the display points on the left-hand side and the right-hand side,
determination of a maximum ordinate value (Y_{MAX}(s), Y_{MAX} (s+1), Y_{MAX} (s+2)) and a minimum ordinate value (Y_{MIN}(s), Y_{MIN}(s+1), Y_{MIN}(s+2)) from the ordinate value of the respective ordinate / abscissa value pair, the respective interpolated ordinate value on the left-hand side (Y_{Lint}(s), Y_{Lint}(s+1), Y_{Lint}(s+2)) and the respective interpolated ordinate value on the right-hand side (Y_{Rint}(s), Y_{Rint}(s+1), Y_{Rint}(s+2)) and
selection of a random or pseudo-random ordinate value (Y_{Z}(s), Y_{Z}(s+1), Y_{z}(s+2)) between the determined maximum ordinate value (Y_{MAX}(s), Y_{MAX}(s+1), Y_{MAX}(s+2)) and the determined minimum ordinate value (Y_{MIN}(s), Y_{MIN}(s+1), Y_{MIN}(s+2)) for each abscissa value (s, s+1, s+2) of the display points by means of multiplication of the difference between the respective determined maximum ordinate value (Y_{MAX}(s), Y_{MAX}(s+1), Y_{MAX}(s+2)) and the respective determined minimum ordinate value (Y_{MIN}(s), Y_{MIN}(s+1), Y_{MIN}(s+2)) with a random scaling factor associated with the respective abscissa value (s, s+1, s+2),
wherein the random scaling factor associated with the respective abscissa value (s, s+1, s+2) is defined by diametrically swapping the bits of a counter state of a counter increased by the associated abscissa value (s, s+1, s+2) and respectively incremented for each individual display image, and
quantization of the selected random or pseudo-random ordinate values (Y_{z}(s), Y_{z}(s+1), Y_{z}(s+2)) of the individual ordinate / abscissa value pairs for display on the display image of the display unit in the ordinate resolution of the display points, wherein the ordinate resolution of the display points is reduced compared with the ordinate resolution of the ordinate / abscissa value pairs.

2. Method according to claim 1,
**characterised in that**
for selection of the random or pseudo-random ordinate value (Y_{z}(s), Y_{z}(s+1), Y_{z}(s+2)) between the maximum ordinate value (Y_{MAX}(s), Y_{MAX}(s+1), Y_{MAX}(s+2)) and the minimum ordinate value (Y_{MIN}(s), Y_{MIN}(s+1), Y_{MIN}(s+2)) an associated random or pseudo-random scaling factor is determined in a value range between zero and one with which the difference between the maximum ordinate value (Y_{MAX}(s), Y_{MAX}(s+1), Y_{MAX}(s+2)) and the minimum ordinate value (Y_{MIN}(s), Y_{MIN}(s+1), Y_{MIN}(s+2)) is multiplied.

3. Method according to claim 2,
**characterised in that**
the random or pseudo-random scaling factor for the selection of a random or pseudo-random ordinate value (Y_{z}(s), Y_{z}(s+1), Y_{z}(s+2)) associated with each abscissa value (s, s+1, s+2) of the display points between two successive abscissa values (s, s+1, s+2) of the display points is scattered as widely as possible in the value range between zero and one.

4. Method according to claim 2 or 3,
**characterised in that**
the random or pseudo-random scaling factor for the selection of a random or pseudo-random ordinate value (Y_{z}(s), Y_{z}(s+1), Y_{z}(s+2)) associated with each abscissa value (s, s+1, s+2) of the display points in a respective identical abscissa value (s, s+1, s+2) of the display points between two successive and parallel processed and displayed signal waveforms is scattered as widely as possible in the value range between zero and one.

5. Method according to claim 4,
**characterised in that**
the counter state is shifted to the left by a number of shift steps corresponding to the log 2 value of the number of parallel processed and displayed signal waveforms and a value corresponding to the position of the respective signal waveform in the sequence of parallel processed signal waveforms is added to the counter state shifted to the left.

6. Method according to one of the claims 2 to 5,
**characterised in that**
for determination of the random or pseudo-random ordinate value (Y_{z}(s), Y_{z}(s+1), Y_{z}(s+2)) associated with the respective abscissa value (s, s+1, s+2) of the display points the associated minimum ordinate value (Y_{MIN}(s), Y_{MIN}(s+1), Y_{MIN}(s+2)) is added to the difference between the maximum ordinate value (Y_{MAX}(s), Y_{MAX}(s+1), Y_{MAX}(s+2)) and the minimum ordinate value (Y_{MIN}(s), Y_{MIN}(s+1), Y_{MIN}(s+2)) multiplied with the associated random or pseudo-random scaling factor.

7. Method according to claim 6,
**characterised in that**
a range of ordinate / abscissa value pairs reduced in the ordinate direction is selected from all the ordinate / abscissa value pairs with respective selected random or pseudo-random ordinate values (Y_{z}(s), Y_{z}(s+1), Y_{z}(s+2)) for display on the display image.

8. Method according to one of claims 1 to 7,
**characterised in that**
the smallest distance between two random or pseudo-random ordinate values (Y_{z}(s), Y_{z}(s+1), Y_{z}(s+2)) corresponds to the smallest distance between two ordinate values of the ordinate / abscissa value pairs.

9. Device for displaying ordinate / abscissa value pairs on a display unit (6) with discrete display points in the abscissa and ordinate directions with
an interpolator (8) for determination of an interpolated ordinate value (Y_{Lint}(s), Y_{Lint}(s+1), Y_{Lint}(s+2), Y_{Rint}(s), Y_{Rint}(s+1), Y_{Rint}(s+2)) on the left-hand side and the right-hand side of each abscissa value (s, s+1, s+2),
a maximum value forming unit (9) for determination of a maximum ordinate value (Y_{MAX}(s), Y_{MAX}(s+1), Y_{MAX}(s+2)) from the ordinate value and the respective interpolated ordinate value (Y_{Lint}(s), Y_{Lint}(s+1), Y_{Lint}(s+2), Y_{Rint}(s), Y_{Rint}(s+1), Y_{Rint}(s+2)) on the left-hand side and the right-hand side,
a minimum value forming unit (10) for determination of a minimum ordinate value (Y_{MIN} (s), Y_{MIN}(s+1), Y_{MIN}(s+2)) from the respective ordinate value and the respective interpolated ordinate value (Y_{Lint}(s), Y_{Lint}(s+1), Y_{Lint}(s+2), Y_{Rint}(s), Y_{Rint}(s+1), Y_{Rint}(s+2)) on the left-hand side and the right-hand side, and
a unit (14) for selection of a random or pseudo-random ordinate value (Y_{z}(s), Y_{z}(s+1), Y_{z}(s+2)) between the determined maximum and minimum ordinate value (Y_{MAX}(s), Y_{MAX}(s+1), Y_{MAX}(s+2), Y_{MIN}(s), Y_{MIN}(s+1), Y_{MIN}(s+2)) for each abscissa value,
wherein the ordinate resolution of the display points is reduced compared with the ordinate resolution of the ordinate / abscissa value pairs,
wherein the unit (14) for selection of a random or pseudo-random ordinate value (Y_{z}(s), Y_{z}(s+1), Y_{z}(s+2)) comprises a subtractor (11) for forming a difference between the maximum and minimum ordinate value (Y_{MAX}(s), Y_{MAX}(s+1), Y_{MAX}(s+2), Y_{MIN}(s), Y_{MIN}(s+1), Y_{MIN}(s+2)) for each abscissa value (s, s+1, s+2), a unit (13) for determination of a random or pseudo-random scaling factor, and a first multiplier (19) for multiplication of the difference between the maximum and minimum ordinate value (Y_{MAX}(s), Y_{MAX}(s+1), Y_{MAX}(s+2), Y_{MIN}(s), Y_{MIN}(s+1), Y_{MIN}(s+2)) with the random or pseudo-random scaling factor,
wherein the unit (13) for determination of a random or pseudo-random scaling factor comprises a counter (12) for incrementation of a counter state with each display image to be displayed, a second adder (17) for addition of the respective abscissa value (s, s+1, s+2) to the counter state of the counter (12), and a unit (18) for diametrically swapping the bits of the counter state increased by the respective abscissa value.

10. Device according to claim 9,
**characterised in that**
the unit (14) additionally comprises a first adder (21) for addition of the minimum ordinate value (Y_{MIN}(s), Y_{MIN}(s+1), Y_{MIN}(s+2)) and the difference multiplied with the random or pseudo-random scaling factor.

11. Device according to claim 9 or 10,
**characterised in that**
connected between the counter (12) and the second adder (17) there is a second multiplier (15) for shifting the counter state to the left by a number of shift steps corresponding to the log 2 value of the number (N) of parallel processed and displayed signal waveforms, and a third adder (16) for addition of the counter state shifted to the left and a value corresponding to the position of the respective signal waveform in the sequence of parallel processed and displayed signal waveforms.

12. Device according to one of claims 9 to 11,
**characterised in that**
connected downstream of the unit (14) for selection of a random or pseudo-random ordinate value (Y_{z}(s), Y_{z}(s+1), Y_{z}(s+2) there is a quantizer (23) for displaying the random or pseudo-random ordinate values (Y_{z}(s), Y_{z}(s+1), Y_{z}(s+2)) determined for each abscissa value (s, s+1, s+2) in ordinate values in the ordinate resolution of the display points.

13. Device according to claim 12,
**characterised in that**
connected between the unit (14) for selection of a random or pseudo-random ordinate value (YZ(s), YZ(s+1), YZ(s+2)) and the quantizer (23) there is an enlarging unit (22) for selection of a range of ordinate / abscissa value pairs which is reduced compared with the ordinate / abscissa value pairs with a respectively determined random or pseudo-random ordinate value (Y_{Z}(s), Y_{Z}(s+1), Y_{Z}(s+2)).

## Revendications

1. Procédé de représentation de paires de valeurs d'ordonnées et d'abscisses sur un dispositif d'affichage au moyen de points d'affichage discrets dans le sens de abscisses et des ordonnées, comprenant les étapes de procédé suivantes, qui sont exécutées par un dispositif de calcul :
la détermination d'une valeur d'ordonnées interpolée (Y_{Lint}(s), Y_{Lint}(s+1), Y_{Lint}(s+2), Y_{Rint}(s), Y_{Rint}(s+1), Y_{Rint}(s+2)) à la moitié de la distance entre la valeur d'abscisses (s, s+1, s+2) respective et la valeur d'abscisses des points d'affichage respectivement situés à gauche et à droite,
la détermination d'une valeur d'ordonnées maximale (Y_{MAX}(s), Y_{MAX}(s+1), Y_{MAX}(s+2) et d'une valeur d'ordonnées minimale (Y_{MIN}(s), Y_{MIN}(s+1), Y_{MIN}(S+2)) à partir de la valeur d'ordonnées de la paire de valeurs d'ordonnées et d'abscisses respective, de la valeur d'ordonnées respective interpolée à gauche (Y_{LINT}(s), Y_{LINT}(s+1), Y_{LINT}(s+2)) et de la valeur d'ordonnées respective interpolée à droite (Y_{Rint}(s), Y_{Rint}(s+1), Y_{Rint}(s+2)) et
le choix d'une valeur d'ordonnées aléatoire ou pseudo-aléatoire (Y_{z}(s), Y_{z}(s+1), Y_{z}(s+2)) entre la valeur d'ordonnées maximale (Y_{MAX}(s), Y_{MAX} (s+1), Y_{MAX}(s+2)) déterminée et la valeur d'ordonnées minimale (Y_{MIN}(s), Y_{MIN}(s+1), Y_{MIN}(s+2)) déterminée pour chaque valeur d'abscisses (s, s+1, s+2) des points d'affichage par multiplication de la différence entre la valeur d'ordonnées maximale (Y_{MAX}(s), Y_{MAX}(s+1), Y_{MAX}(s+2)) déterminée respective et la valeur d'ordonnées minimale (Y_{MIN}(s), Y_{MIN}(s+1), Y_{MIN}(s+2)) déterminée respective par un facteur d'échelle aléatoire appartenant à la valeur d'abscisses (s, s+1, s+2) respective,
dans lequel le facteur d'échelles aléatoire appartenant à la valeur d'abscisses (s, s+1, s+2) respective est défini par un échange diamétralement opposé des bits d'un comptage d'un compteur augmenté de la valeur d'abscisses (s, s+1, s+2) associée et respectivement incrémenté pour chaque image d'affichage individuelle, et
la quantification des valeurs d'ordonnées aléatoires ou pseudo-aléatoires (Y_{z}(s), Y_{z}(s+1), Y_{z}(s+2)) choisies parmi les différentes paires de valeurs d'ordonnées et d'abscisses pour leur représentation sur l'image d'affichage du dispositif d'affichage dans la résolution de l'ordonnée des points d'affichage, dans lequel la résolution de l'ordonnée des points d'affichage est réduite par rapport à la résolution de l'ordonnée des paires de valeurs d'ordonnées et d'abscisses.

2. Procédé selon la revendication 1,
**caractérisé**
**en ce que**, pour choisir la valeur d'ordonnées aléatoire ou pseudo-aléatoire (Y_{z}(s), Y_{z}(s+1), Y_{z}(s+2)) entre la valeur d'ordonnées maximale (Y_{MAX}(s), Y_{MAX}(s+1), Y_{MAX} (s+2)) et la valeur d'ordonnées minimale (Y_{MIN}(s), Y_{MIN}(s+1), Y_{MIN}(s+2)), un facteur d'échelle aléatoire ou pseudo-aléatoire est déterminé dans une plage de valeurs comprise entre zéro et un, par lequel la différence entre la valeur d'ordonnées maximale (Y_{MAX}(s), Y_{MAX}(s+1), Y_{MAX}(s+2)) et la valeur d'ordonnées minimale (Y_{MIN}(s), Y_{MIN}(s+1), Y_{MIN}(s+2)) est multipliée.

3. Procédé selon la revendication 2,
**caractérisé**
**en ce que** le facteur d'échelles aléatoire ou pseudo-aléatoire, pour le choix d'une valeur d'ordonnées aléatoire ou pseudo-aléatoire (Y_{z}(s), Y_{z}(s+1), Y_{z}(s+2)), entre deux valeurs d'abscisses (s, s+1, s+2) successives des points d'affichage, est dispersé autant que possible dans la plage de valeurs comprise entre zéro et un.

4. Procédé selon la revendication 2 ou 3,
**caractérisé**
**en ce que** le facteur d'échelles aléatoire ou pseudo-aléatoire, pour le choix d'une valeur d'ordonnées aléatoire ou pseudo-aléatoire (Y_{z}(s), Y_{z}(s+1), Y_{z}(s+2)) appartenant à chaque valeur d'abscisses (s, s+1, s+2) des points d'affichage, dans respectivement une valeur d'abscisses (s, s+1, s+2) identique des points d'affichage entre deux variations de signal successives et traitées parallèlement et représentées, est dispersé autant que possible dans la plage de valeurs comprise entre zéro et un.

5. Procédé selon la revendication 4,
**caractérisé**
**en ce que** le comptage du compteur est amené à glisser vers la gauche d'un nombre d'étapes de glissement correspondant à la valeur log-2 du nombre de variations de signal traitées parallèlement et représentées, et une valeur correspondant à la position de la variation de signal respective dans la séquence de variations de signal traitées parallèlement est additionnée au comptage du compteur ayant glissé vers la gauche.

6. Procédé selon l'une quelconque des revendications 2 à 5,
**caractérisé**
**en ce que**, pour déterminer la valeur d'ordonnées aléatoire ou pseudo-aléatoire (Y_{z}(s), Y_{z}(s+1), Y_{z}(s+2)) appartenant à la valeur d'abscisses (s, s+1, s+2) respective des points d'affichage, la valeur d'ordonnées minimale (Y_{MIN}(s), Y_{MIN}(s+1), Y_{MIN}(s+2)) associée est additionnée à la différence entre la valeur d'ordonnées maximale (Y_{MAX}(s), Y_{MAX}(s+1), Y_{MAX}(s+2)) et la valeur d'ordonnées minimale (Y_{MIN}(s), Y_{MIN}(s+1), Y_{MIN}(s+2)), multipliée par le facteur d'échelle aléatoire ou pseudo-aléatoire associé.

7. Procédé selon la revendication 6,
**caractérisé**
**en ce qu'**une plage réduite dans le sens des ordonnées de paires de valeurs d'ordonnées et d'abscisses est choisie parmi toutes les paires de valeurs d'ordonnées et d'abscisses comprenant chacune des valeurs d'ordonnées aléatoires ou pseudo-aléatoires (Y_{z}(s), Y_{z}(s+1), Y_{z}(s+2)) choisies pour être représentées sur l'image d'affichage.

8. Procédé selon l'une quelconque des revendications 1 à 7,
**caractérisé**
**en ce que** le plus petit écart entre deux valeurs d'ordonnées aléatoires ou pseudo-aléatoires (Y_{z}(s), Y_{z}(s+1), Y_{z}(s+2)) correspond au plus petit écart entre deux valeurs d'ordonnées des paires de valeurs d'ordonnées et d'abscisses.

9. Dispositif de représentation de paires de valeurs d'ordonnées et d'abscisses sur un dispositif d'affichage (6) au moyen de points d'affichage discrets dans le sens des abscisses et des ordonnées, comprenant
un interpolateur (8) destiné à déterminer une valeur d'ordonnées interpolée (Y_{Lint}(s), Y_{Lint}(s+1), Y_{Lint}(s+2), Y_{Rint}(s), Y_{Rint}(s+1), Y_{Rint}(s+2)) à gauche et à droite de chaque valeur d'abscisses (s, s+1, s+2),
un formateur de valeur maximale (9) destiné à déterminer une valeur d'ordonnées maximale (Y_{MAX}(s), Y_{MAX}(s+1), Y_{MAX}(s+2)) à partir de la valeur d'ordonnées et de la valeur d'ordonnées interpolée (Y_{Lint}(s), Y_{Lint}(s+1), Y_{Lint}(s+2), Y_{Rint}(S), Y_{Rint}(s+1), Y_{Rint}(s+2)) à gauche et à droite respective,
un formateur de valeur minimale (10) destiné à déterminer une valeur d'ordonnées minimale (Y_{MIN}(s), Y_{MIN}(s+1), Y_{MIN}(s+2)) à partir de la valeur d'ordonnées respective et de la valeur d'ordonnées interpolée (Y_{Lint}(s), Y_{Lint}(s+1), Y_{Lint}(s+2), Y_{Rint}(s), Y_{Rint}(s+1), Y_{Rint}(s+2)) à gauche et à droite respective et
une unité (14) destinée à choisir une valeur d'ordonnées aléatoire ou pseudo-aléatoire (Y_{z}(s), Y_{z}(s+1), Y_{z}(s+2)) entre la valeur d'ordonnées maximale et minimale (Y_{MAX}(s), Y_{MAX}(s+1), Y_{MAX}(s+2), Y_{MIN}(s), Y_{MIN}(s+1), Y_{MIN}(s+2)) déterminée de chaque valeur d'abscisses,
dans lequel la résolution de l'ordonnée des points d'affichage est réduite par rapport à la résolution de l'ordonnée des paires de valeurs d'ordonnées et d'abscisses,
dans lequel l'unité (14) destinée à choisir une valeur d'ordonnées aléatoire ou pseudo-aléatoire (Y_{z}(s), Y_{z}(s+1), Y_{z}(s+2)) comprend un soustracteur (11) destiné à former une différence entre la valeur d'ordonnées maximale et minimale (Y_{MAX}(s), Y_{MAX}(s+1), Y_{MAX}(s+2), Y_{MIN}(s), Y_{MIN}(s+1), Y_{MIN}(s+2)) de chaque valeur d'abscisses (s, s+1, s+2), une unité (13) destinée à déterminer un facteur d'échelle aléatoire ou pseudo-aléatoire et un premier multiplicateur (19) destiné à multiplier la différence entre la valeur d'ordonnées maximale et minimale (Y_{MAX}(s), Y_{MAX}(s+1), Y_{MAX}(s+2), Y_{MIN}(s), Y_{MIN}(s+1), Y_{MIN}(s+2)) par le facteur d'échelle aléatoire ou pseudo-aléatoire,
dans lequel l'unité (13) destinée à déterminer un facteur d'échelle aléatoire ou pseudo-aléatoire comprend un compteur (12) destiné à incrémenter un comptage de compteur avec chaque image d'affichage à représenter, un deuxième additionneur (17) destiné à additionner la valeur d'abscisses (s, s+1, s+2) respective au comptage du compteur (12) et une unité (18) pour l'échange diamétralement opposé des bits du comptage du compteur augmenté de la valeur d'abscisses respective.

10. Dispositif selon la revendication 9,
**caractérisé**
**en ce que** l'unité (14) présente en plus un premier additionneur (21) destiné à additionner la valeur d'ordonnées minimale (Y_{MIN}(s), Y_{MIN}(s+1), Y_{MIN}(s+2)) et la différence multipliée par le facteur d'échelle aléatoire ou pseudo-aléatoire.

11. Dispositif selon la revendication 9 ou 10,
**caractérisé**
**en ce qu'**un deuxième multiplicateur (15) permettant le glissement vers la gauche du comptage du compteur d'un nombre d'étapes de glissement correspondant à la valeur log-2 du nombre (N) de variations de signal traitées parallèlement et représentées et un troisième additionneur (16) destiné à additionner le comptage du compteur ayant glissé vers la gauche et une valeur correspondant à la position de la variation de signal respective dans la séquence de variations de signal traitées parallèlement et représentées sont montés entre le compteur (12) et le deuxième additionneur (17).

12. Dispositif selon l'une quelconque des revendications 9 à 11,
**caractérisé**
**en ce qu'**un quantificateur (23) destiné à reproduire les valeurs d'ordonnées aléatoires ou pseudo-aléatoires (Y_{z}(s), Y_{z}(s+1), Y_{z}(s+2)) déterminées pour chaque valeur d'abscisses (s, s+1, s+2) en valeurs d'ordonnées dans la résolution de l'ordonnée des points d'affichage est monté en aval de l'unité (14) destinée à choisir une valeur d'ordonnées aléatoire ou pseudo-aléatoire (Y_{z}(s), Y_{z}(s+1), Y_{z}(s+2)).

13. Dispositif selon la revendication 12,
**caractérisé**
**en ce qu'**une unité d'agrandissement (22) destinée à choisir une plage de paires de valeurs d'ordonnées et d'abscisses qui est réduite par rapport aux paires de valeurs d'ordonnées et d'abscisses présentant chacune une valeur d'ordonnées aléatoire ou pseudo-aléatoire (Y_{z}(s), Y_{z}(s+1), Y_{z}(s+2)) déterminée est montée entre l'unité (14) destinée à choisir une valeur d'ordonnées aléatoire ou pseudo-aléatoire (Y_{z}(s), Y_{z}(s+1), Y_{z}(s+2)) et le quantificateur (23).
